# EUROPEAN PATENT APPLICATION

(11) **EP 2 458 622 A2**
(43) Date of publication of application: **30.05.2012**
(21) Application number: 11190545.1
(22) Date of filing: 24.11.2011
(51) Int. Cl.: H01L 21/306, H01L 31/18, H01L 31/0236

(54) **Compositions and methods for texturing of silicon wafers**

(30) Priority: 24.11.2010 US 416998 P; 02.09.2011 US 530760 P; 15.11.2011 US 296836
(71) Applicant: Air Products and Chemicals, Inc., Allentown, PA 18195-1501 (US)
(72) Inventor: Tamboli, Dnyanesh Chandrakant, Breinigsville, PA 18031 (US); Rao, Madhukar Bhaskara, Fogelsville, PA 18051 (US); Wu, Aiping, Macungie, PA 18062 (US)
(74) Representative: Westendorp | Sommer

(57) **Abstract**

Pre-texturing composition for texturing silicon wafers having one or more surfactants. Methods of texturing silicon wafers having the step of wetting said wafer with a pre-texturing composition having one or more surfactants followed by a texturing step.

## Description

### CROSS-REFERENCE TO RELATED APPLICATIONS

This Application claims the benefit of Provisional U.S. Patent Application No. 61/416,998 filed November 24, 2010 (Attorney Docket No. 07482Z) and Provisional U.S. Patent Application No. 61/530,760 filed September 2, 2011 (Attorney Docket No. 07482Z2), which are entirely incorporated herein by reference.

### BACKGROUND OF THE INVENTION

This invention relates to texturing of a surface of a photovoltaic wafer. For improving the efficiency of conversion of light energy to electricity, a very low reflecting silicon surface is desired. For monocrystalline silicon for example, this is achieved by anisotropic etching of (100) Si wafers to form pyramid structures on the surface, in a process called texturing. A uniform and dense distribution of pyramids is desired on the surface of the silicon wafer to achieve low reflectance. It is desired that the pyramid heights be less than 10 µm and be uniform in size. Smaller and uniform pyramid structures ensure good coverage by the passivation layer which is deposited on the top of the textured surface again to prevent losses in efficiency. Smaller and uniform pyramid structures also ensure that metal contact lines printed on the silicon surface are narrower, allowing more light to pass through to the silicon surface for the photo-electron conversion.

Prior art references include: WO 2009120631 A2, CN 101634026 A, CN 101634027 A, DE 102007058829 A1, WO 2009119995 A2, US 4137123 A, CN 101217173 A, CN 1983644 A, CN 1983645 A, JP 2009123811 A, EP 944114 A2, EP 1890338 A1, Basu, P.K. Et al, Solar Energy Materials & Solar Cells (2010), 94(6), 1049-1054, Basu P.K. et al, Renewable Energy (2009), 34(12), 2571-2576, WO 2009071333, Gangopadhyay U. et al., Solar Energy Materials & Solar Cells (2006), 90(18-19), 3094-3101 and WO 2008022671.

### BRIEF SUMMARY OF THE INVENTION

This invention provides pre-texturing compositions for the use in the method of texturing of a silicon wafer comprising surfactant; and pre-texturing compositions comprising one or more cationic, non-ionic, zwitterionic and anionic surfactants and mixtures thereof. This invention further provides pre-texturing compositions for the use in the texturing method of a silicon wafer comprising or further comprising one or more silicone surfactants. This invention further provides pre-texturing compositions comprising, consisting of, or consisting essentially of the one or more surfactants and water or one or more surfactants, water and acid. This invention further provides pre-texturing compositions for use in a texturing method comprising, consisting of, or consisting essentially of one or more cationic, non-ionic, zwitterionic and anionic surfactants and water, and/or one or more silicone surfactants and water or one or more cationic, non-ionic, zwitterionic and anionic surfactants, water and acid, and/or one or more silicone surfactants water and acid. Any of the above-described compositions may further comprise, consist essentially of, or consist of one or more acids and/or one or more bases and/or one or more defoaming agents and/or one or more other additives.

This invention further provides methods of texturing a silicon wafer comprising the step of wetting said wafers with one or more pre-texturing compositions of this invention comprising one or more surfactants, and methods of texturing a silicon wafer comprising the step of wetting said wafer with a pre-texturing composition comprising cationic, non-ionic, zwitterionic, anionic surfactant and/or silicone surfactant, and methods of texturing silicon wafers comprising the steps of: wetting said wafer with a pre-texturing composition comprising surfactant; and wetting said wafer with an etching composition. Any of the above-described pre-texturing compositions may be used in the methods of this invention.

Compositions of this invention can be used to treat silicon wafers or substrates or silicon films deposited on a different type of substrate (the terms substrate or wafer will be used interchangeably herein and in the claims to refer to all of these) in the texturing processes of this invention. The silicon wafers treated in accordance with these inventions may be used to make photovoltaic cells. Wafers subjected to compositions and/or methods of this invention may show improvement in the texturing uniformity and reduced reflectivity compared to the wafers not subjected to this treatment. Additional benefits that may be achieved with the method and/or composition of this invention may include one or more of the following: (1) the creation of pyramid structures on the surface of the wafer having high density and having an average height less than 10 µm, or less than 8 µm or less than 5 µm or less than 4 µm; (Often in the absence of the treatment in accordance with this invention, the average pyramid heights can be in excess of 10 µm.) (2) decreased reflectance of the textured surface; (3) decreased time needed to form pyramids and/or form the textured surface with low reflectance; (4) lower sensitivity of texturing quality to isopropyl alcohol concentration in the texturing process and in some embodiments texturing may be performed without any isopropyl alcohol or any other additive needed to promote texturing in the one or more texturing compositions; (5) when the pre-texturing composition and step is used in the texturing process, the need for additives in the texturing (etching) composition or solution to improve quality and throughput of texturing may be reduced or eliminated; (6) reduction in the total amount of silicon etched in the texturing step (7) increased bath life of the texturing composition also referred to as texturing or etching solution (8) improved coverage of passivation layer (9) narrower metal contact lines printed on the front of the wafer; (10) increased wettability of the silicon surface prior to texturing, and (11) improvement in the electrical test parameters of the finished solar cells. Electrical test parameters could include, for example, short circuit currents, open circuit voltage, and photo-electron conversion efficiency. Pre-texturing with compositions or formulations (those terms will be used interchangeably herein), used in the methods of texturing in this invention, for some embodiments, reduces the time for texturing to 30 minutes or less, 20 minutes or less, 10 minutes or less, or 5 minutes or less as compared to conventional prior art texturing processes. This results in decreased processing time for some embodiments and therefore increased throughput for the wafer processing. In some embodiments, when the pre-texturing compositions or formulations are used in the methods of this invention, the pyramid size and density and wafer reflectivity also changes little with time or shows little sensitivity to the concentrations of the one or more texturing compositions in the one or more texturing baths during the texturing process, thus resulting in improvements in the robustness of the process; therefore longer or shorter texturing times may be used, if there is a process upset, without detriment to performance of the photovoltaic device.

### BRIEF DESCRIPTION OF SEVERAL VIEWS OF THE DRAWINGS

FIG. 1 depicts a process flow diagram of a surface texturing process performed on a silicon substrate in accordance with one embodiment of the invention;

FIGS. 2A-2B depicts cross-sectional views of a portion of a substrate corresponding to various stages of the process of FIG. 1;

FIG. 3A-3C are scanning electron micrographs of monocrystalline Si wafers from a first source treated in accordance with Processes A, B and C respectively as described in Example 1.

FIG. 4A-4C are scanning electron micrographs of monocrystalline Si wafers from a second source treated in accordance with Processes A, B and C respectively as described in Example 1.

FIG. 5A-5D are scanning electron micrographs of monocrystalline Si wafers from a second source treated in accordance with Process A using various etching times (5 minutes, 10 minutes, 15 minutes and 20 minutes, respectively) as described in Example 3.

FIG. 6A-6D are scanning electron micrographs of monocrystalline Si wafers from a second source treated in accordance with Process B of the invention using various etching times (5 minutes, 10 minutes, 15 minutes and 20 minutes, respectively) as described in Example 3.

FIG. 7A-7D are scanning electron micrographs of monocrystalline Si wafers from a second source treated in accordance with Process C of the invention using various etching times (5 minutes, 10 minutes, 15 minutes and 20 minutes, respectively) as described in Example 3.

FIG. 8 is a graph of the percent reflectance versus the texturing (etching) time for the wafers treated using three different texturing processes described in Example 3.

FIG. 9 is a top-down scanning electron micrograph of the surface of the silicon wafer treated in accordance with the process of the invention described in Example 5.

FIG 10 is a graph of the percent reflectance versus IPA concentration in the texturing (etching) composition with and without treatment with the pre-texturing composition.

To facilitate understanding, identical reference numerals have been used, where possible, to designate identical elements that are common to the figures. It is to be noted, that the appended drawings illustrate only exemplary embodiments of this invention and are therefore not to be considered limiting of its scope, for the invention may admit to other equally effective embodiments.

### DETAILED DESCRIPTION OF THE INVENTION

Photovoltaic mono-crystalline silicon wafer processing typically involves a first step or steps of cleaning to remove any contamination and removing saw damage of the cut wafers (cut from ingots) typically in concentrated alkali solutions, followed by texturing in dilute alkaline solutions to generate pyramid texture on the surface, which reduces the reflectivity of the surface and allows more light to be converted to electricity thereby increasing the efficiency of the wafer. For multicrystalline silicon wafers processing may involve first step or steps of cleaning to remove any contamination directly followed by texturing. It is desirable to have as low reflectivity as possible. Our invention provides compositions and methods to improve the texturing of the surface of the wafer. Our invention involves treating the wafer surface with a pre-texturing composition that typically comprises one or more surfactants or one or more surfactants and one or more solvents (which may be water) in a solution. The composition modifies the wafer surface and results in high nucleation density of pyramids in the case of texturing monocrystalline silicon wafers, resulting in a desired uniform distribution of small pyramids. For multicrystalline silicon wafers the surface modification improves the uniformity of the textured surface and can result in lower surface reflectivity.

The composition of this invention may be used in at least one pre-texturing step in a multi-step method of texturing a wafer that may be a monocrystalline substrate (e.g., Si<100> or Si<111>), a microcrystalline silicon substrate, multi-crystalline silicon substrate, a strained silicon substrate, an amorphous silicon substrate, a doped or undoped polysilicon substrate, glass, sapphire or any type of silicon containing substrate. The substrate may also be a film of silicon deposited on a different type of substrate such as a metal, glass or polymer. The pre-texturing step that precedes the texturing step is a pretreatment step that involves the use of the composition of this invention comprising a surfactant or mixtures of more than one surfactant in a solution. It is believed that the composition comprising one or more surfactants improves (decreases) the reflectance of the wafers after or during the pre-texturing step(s) and texturing step(s). The pre-texturing step will use the composition of this invention comprising the surfactant, and the texturing step may be any standard texturing or etching step using any known etching composition or etching solution, also commonly referred to as a wet etchant. For example, the texturing step may use a standard texturing solution in a standard texturing bath.

The pre-texturing composition of this invention used in a pre-texturing step provides the added benefit that it cleans the silicon surface. After the texturing process is complete, the texturing quality is improved, with the formation of high density, small pyramids for the case of moncrystalline silicon and a more uniform textured surface for the case of multicrystalline silicon, leading to lower reflectance. As stated the pre-texturing compositions of this invention comprise one or more surfactants. Any type of surfactants, such as anionic, cationic, non-ionic, zwitterionic surfactants or combinations thereof may be used. In some embodiments, the surfactants used in the compositions of the invention herein are those that reduce surface tension. The surfactants useful in the pre-texturing composition of this invention include molecules having a large or long carbon atom chain (more than 5 carbon atoms in the chain) and contain a polar group and a non-polar group in the molecule.

The pre-texturing compositions may comprise one or more surfactants and at least one may be selected from non-ionic surfactants including, but not limited to: alkylphenol ethoxylates, alcohol ethoxylates, polyoxyethylenated polyoxypropylene glycols, polyoxyethylenated mercaptans, long chain carboxylic acid esters (the use of "long chain" herein means greater than 5 carbons in the chain, for example, in many embodiments the long chain may comprise between from 5-20,000 carbons), glyceryl and polyglyceryl esters of natural fatty acids, propylene glycol esters, sorbitol esters, polyoxyethylenated sorbitol esters, polyoxyethylene glycol esters, polyoxyethylenated fatty acids, alkanol amides, acetylenic glycols, polyoxyethylenated silicones, n-alkylpyrrolidones, alkylpolyglycosides, silicone surfactants, and fluorochemical surfactants or mixtures thereof of these and any surfactants disclosed herein. Silicone surfactants may be referred to as polymerized siloxanes or polysiloxanes and are mixed inorganic-organic polymers with the chemical formula [R₂SiO]ₙ, where R is an organic group such as methyl, ethyl, or phenyl and n is greater than 1. The silicone surfactants may be added in the concentration of 0.001 to 10 wt% to the pre-texturing compositions. More preferable range is 0.001 to 1 wt%. An example of a commercially available silicone surfactant is DOW Antifoam 1430.

The pre-texturing composition may comprise one or more surfactants at least one of which may comprise a non-ionic surfactant for use in the process composition. Non-ionic surfactants include, but are not limited to: alkyl phenol ethoxylates, such as; TRITON® X-100, X-705, X-114, X-102, X-45, X-15, Tergitol® NP-9, NP-30 (available from Dow Chemicals); alcohol ethoxylates, such as; Tergitol™15-S-7, 15-S-30, TMN-6, TMN-10 (available from Dow Chemicals); polyethylene glycols (molecular weights ranging from 100 to 1000000); and acetylenic diols or mixtures thereof or with any of the surfactants disclosed herein. Examples of acetylenic diol surfactants include Surfynol® 485, 465 and 2502 and Dynol® 604 manufactured by Air Products and Chemicals, Inc. The pre-texturing composition may comprise one or more surfactants at least one of which may comprise an anionic surfactant such as linear alkylbenzenesulfonates (LAS), straight chain fatty acids and/or salts thereof, coconut oil fatty acid derivatives, tall oil acid derivatives, sarcosides, aceylated polypeptides, secondary alylbenzenesulfonate, lignin sulfonates, N-acyl-n-alkyltaurates, fatty alcohol sulfates (FAS), petroleum sulfonates, secondary alkanesulfonates (SAS), paraffin sulfonates, fatty alcohol ether sulfates (FAES), α-Olefin sulfonates, sulfosuccinate esters, alkylnapthalenesulfonates, isethionates, sulfuric acid esters, sulfated linear primary alcohols, sulfated polyoxyethylenated straight chain alcohols, sulfated triglyceride oils, phosphoric and polyphosphoric acid esters and perfluorinated anionics and mixtures thereof of these and any of the surfactants disclosed herein. The texturing compositions may comprise α-olefin sulfonates having the following structure: 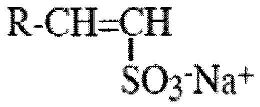 wherein R is an alkyl group, for example, a straight-chain alkyl group, having between from 10 to 18 carbons.

The pre-texturing composition may comprise one or more surfactants at least one of which may comprise cationic surfactants including long chain amines and their salts, diamines and polyamines and their salts, quaternary ammonium salts, polyoxyethylenated long chain amines, quaternized polyoxyethylenated (POE) long chain amines, and amine oxides and mixtures thereof of these and any of the surfactants disclosed herein. Example of cationic surfactant is Tomadyne 102 manufactured by Air Products and Chemicals, Inc.. The pre-texturing composition may comprise one or more surfactants at least one of which may comprise zwitterionic surfactants including N-alkyl derivatives of simple amino acids, such as glycine, betaine and amino propionic acids, imidazolines, sulfobetaines, and amine oxides and mixtures thereof of these and any of the surfactants disclosed herein. Commercially available surfactants useful in the texturing compositions of this invention include: Hostapur® SAS a secondary alkane sulfate-sodium salt manufactured by Clariant Corporation; Calfax^{®}DBA70 a C12 (branched) diphenyl oxide dislfonic acid manufactured by Pilot Chemical Company; Calfoam ® ES-302 (Sodium lauryl ether sulfate) manufactured by Pilot Chemical Company, Calfoam ® ALS-30 (Sodium lauryl sulfate) manufactured by Pilot Chemical Company, AEROSOL^{®}NPES - 3030 P an ether sulfate manufactured by CYTEC CANADA, Inc., and Dequest^{®}, a sulfonated acrylic co-polymer from ThermPhos.

Still further exemplary surfactants, that compositions of this invention may comprise include: acetylenic diol type surfactants, alcohol (primary and secondary) ethoxylates, phenyl ethoxylates, amine ethoxylates, glucosides, glucamides, polyethylene glycols, poly(ethylene glycol-co-propylene glycol), or other surfactants provided in the reference: McCutcheon's Emulsifiers and Detergents, North American Edition for the Year 2000 published by Manufacturers Confectioners Publishing Co. of Glen Rock, N.J. Any of the surfactants or mixtures of the surfactants may be used in the pre-texturing compositions of this invention in any amounts or at concentrations from 0.01 wt% to 30 wt%, or from 2 to 30 wt%, or from 6 wt% to 30 wt%, or from 0.1 wt% to 20 wt%, or from 0.5 wt% to 20 wt%, or from 1 to 20 wt%, or from 2 to 20 wt%, or from 1 to 15 wt%, or greater than 5 to 30 wt %, or 1.5 to 20 wt% or 0.5 to 10 wt%. Alternatively surfactant solutions comprising surfactants in amounts greater than 0.01 wt%, or greater than 1 wt%, or greater than 1.5 wt%, or greater than 5 wt%, or greater than 6 wt% or greater than 10 wt% may be useful in the pre-texturing compositions. In many embodiments, the pre-texturing compositions are aqueous solutions. Note that the weight percentages (wt %), like all of the wt % herein, are based on the total weight of the pre-texturing, texturing or other solution, composition or formulation. Any volume % defined herein are also based on the total volume of the pre-texturing or other solution, composition or formulation being described. Useful surfactants may be purified using suitable techniques to remove metallic impurities. Purifying the surfactant may be one of the first steps performed when preparing the pre-texturing composition of this invention. One useful purification technique is performing an ion exchange of the surfactant. In most embodiments, the pre-texturing formulations are made by combining all the ingredients in a suitable container (which may be the bath) and stirring or otherwise mixing the composition. If necessary, the composition may be heated during the mixing to aid the formation of the solution.

Further, the surfactant used in the pre-texturing composition of this invention may be one or more of an anionic surfactant or a surfactant with a sulfate or a sulfonic functional group or a secondary alkane sulfonate surfactant or an alkyl sulfate surfactant or mixtures thereof. The surfactants may be used in free acid form as well as salt form. The surfactant having a sulfonate group may have the following structure: 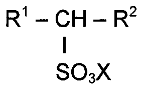 where R¹ and R² are independently straight chain or cyclic alkyl groups or phenyl groups or combinations, typically comprising 1-20 carbons and X is hydrogen or any cation, including Na, K, tetramethyl ammonium, tetraethyl ammonium, triethanol amine, or ammonium. In some embodiments the sulfonic surfactants comprise straight chain alkyl groups.

An example of the surfactant is Hostapur® SAS surfactant commercially available from Clariant, comprising molecules having the following structure: 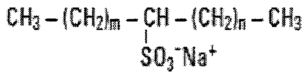 m + n = 10 - 14; the sulphonate group is distributed over
the carbon chain in such away that it is the secondary
carbon atoms that are substituted.

Further, the surfactant used in the pre-texturing composition of this invention may be fatty alcohol sulfates, which are derived from sulfonation of fatty alcohols with carbon chain length ranging from 8 to 22 atoms. An example of surfactant useful in the pre-texturing compositions of this invention is sodium lauryl sulfate with the molecular formula C₁₂H_{25O}.(C₂H_{4O})₂.SO₃.Na. The carbon chain length may vary for commercially manufactured surfactants of this type from 10 carbon atoms to 18 carbon atoms. The surfactant may also contain distributions of various carbon chain length surfactants.

Another example of surfactants that can be used in the pre-texturing compositions of this invention include sodium laureth sulfates having the following structure: 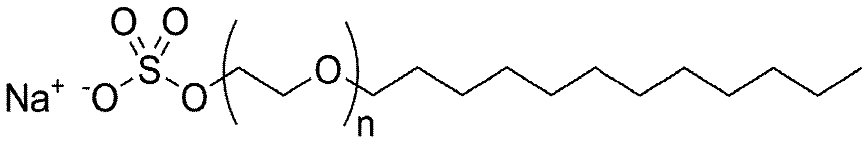 where "n" the number of ethoxylate groups in the surfactant chain and can vary from 1 to 5. The carbon chain length may vary for commercially manufactured surfactants of this type from 10 carbon atoms to 18 carbon atoms. The surfactant may also contain distributions of various carbon chain length surfactants.

The pre-texturing composition of this invention may comprise an n-alkyl betaine surfactants. These surfactants are zwitterionic in nature and may show anionic characteristics in acidic pH and cationic characteristics in the alkaline pH. Another example of a surfactant useful in the pre-texturing composition is N-N-dimethyl-N dodecylglycine betaine with the linear molecular formula CH₃(CH₂)₈₋₁₄CH₂N+(CH₃)₂CH₂COO-Na, sold through Sigma Aldrich Chemicals under the trade name of Empigen®BB. Another example is N-N-dimethyl-N dodecylglycine betaine with the linear molecular formula CH₃(CH₂)₈-₁₄CH₂N+(CH₃)₂CH₂COO-Na. The carbon chain length may vary for commercially manufactured surfactants of this type from 10 carbon atoms to 18 carbon atoms. The surfactant may also contain distributions of various carbon chain length surfactants. Other examples of alkyl betaine surfactants include myristyl betaine, coco betaine, cocamidopropyl betaine and oleyl betaine.

The pre-texturing composition may comprise one or more of the surfactants selected from the surfactants disclosed above. In one embodiment, a silicone containing surfactant may be added to a pre-texturing composition comprising a first surfactant or a mixture of surfactants to improve the texturing performance. The said first surfactant may be any other type of anionic, zwitterionic, cationic or nonionic surfactant. In some embodiments, the first surfactant may be chosen from a group of surfactants comprising of alkyl sulfates, alklyl sulfonates, secondary alkane sulfonates, fatty alcohol sulfates, alcohol ether sulfates, α-olefin sulfonates and alkyl betaines. An example of silicone containing surfactant is Dow Antifoam 1430. When used as the second surfactant the concentration of silicone containing surfactant may range from 0.001 wt% to 2 wt%, and the concentration of the first surfactant or mixture of surfactants may range from 0.1wt% to 10 wt%. In another embodiment, one surfactant may be used to solubilize a less-soluble hydrophobic surfactant molecule. Optional solvosurfactant molecules can be used to increase solubility of difficult to dissolve surfactants, such as acetylenic diol surfactants. The choice of the one or more surfactants may depend upon its or their ability to modify the wafer surface to nucleate the pyramids and clean the surface.

The pre-texturing composition comprising surfactant may also comprise one or more additives to promote cleaning and/or texturing (etching) of the wafer surface. Cleaning additives would help remove debris remaining on the surface even after a saw damage removal step, for example, if any. Optionally the pre-texturing composition of this invention may comprise one or more additional components including inorganic or organic acids, bases, chelating agents, dispersants and defoaming agents or mixtures thereof. Acids and bases and other additives may be added to the pre-texturing composition for example to improve its cleaning performance.

Organic acids function to improve the removal of trace metals, organic and inorganic residues. Organic acids can be chosen from a broad range of acids, including but not limited to: oxalic acid, citric acid, maliec acid, malic acid, malonic acid, gluconic acid, glutaric acid, ascorbic acid, formic acid, acetic acid, ethylene diamine tetraacetic acid, diethylene triamine pentaacetic acid, glycine, alanine, cystine, sulfonic acid, various derivatives of sulfonic acid, etc or mixtures thereof. Salts of these acids may also be used. A mixture of these acids/salts may be used as well.

The pre-texturing composition may further comprise inorganic acids and/or their salts. The inorganic acids and/or their salts may be used in combination with other organic acids and/or their salts. Examples of inorganic acids include hydrochloric acid, nitric acid, sulfuric acid, phosphoric acid, hydrofluoric acid, sulfamic acid, etc. A mixture of these acids/salts may be used as well.

The pre-texturing compositions of this invention may contain any amounts of acids and/or their salts (acids/salts) or from 0 to 30 wt% or 0.001 to 30 wt% of the acids/salts. Acids may be present in any amount or in a range from 0.1 to 10 wt% or from 0.1 to 5 wt %. A combination of acids and salts may also be used to buffer the solution at the desired pH level. When the acids/salts are added to pre-texturing compositions, they are typically used in amounts between from 0.25 to 10 wt % or between from 0.5 to 5 wt % based on the total weight of the pre-texturing composition. Acids/salts may be added to etching/texturing compositions also. When the acids/salts are added to etching compositions, they are typically used in amounts between from 0 to 10 wt % or between from 0 to 5 wt % based on the total weight of the etching composition. In some embodiments the pre-texturing and/or texturing compositions are free of or substantially free ("substantially free" means less than 0.001 wt% any where it is used except if otherwise defined herein) of acids and/or a mixture of acids and their salts.

The pre-texturing compositions used in the method of this invention may further comprise one or more bases. The base may be selected from a range of chemicals, including but not limited to: ammonium hydroxide, potassium hydroxide, a quaternary ammonium hydroxide, an amine, guanidiene carbonate, and organic bases. The bases may be used either alone or in combination with other bases. Examples of suitable organic bases include, but are not limited to: hydroxylamines, ethylene glycol, glycerol, organic amines such as primary, secondary or tertiary aliphatic amines, alicyclic amines, aromatic amines and heterocyclic amines, aqueous ammonia, and quaternary ammonium hydroxides. Specific examples of the hydroxylamines include: hydroxylamine (NH₂OH), N-methylhydroxylamine, N,N-dimethylhydroxylamine and N,N-diethylhydroxylamine. Specific examples of the primary aliphatic amines include: monoethanolamine, ethylenediamine and 2-(2-aminoethylamino)ethanol. Specific examples of the secondary aliphatic amines include: diethanolamine, N-methylaminoethanol, dipropylamine and 2-ethylaminoethanol. Specific examples of the tertiary aliphatic amines include: dimethylaminoethanol and ethyldiethanolamine. Specific examples of the alicyclic amines include: cyclohexylamine and dicyclohexylamine. Specific examples of the aromatic amines include: benzylamine, dibenzylamine and N-methylbenzylamine. Specific examples of the heterocyclic amines include: pyrrole, pyrrolidine, pyrrolidone, pyridine, morpholine, pyrazine, piperidine, N-hydroxyethylpiperidine, oxazole and thiazole. Specific examples of quaternary ammonium salts include: tetramethylammonium hydroxide (TMAH), tetraethylammonium hydroxide, tetrapropylammonium hydroxide, trimethylethylammonium hydroxide, (2-hydroxyethyl)trimethylammonium hydroxide, (2-hydroxyethyl)triethylammonium hydroxide, (2-hydroxyethyl)tripropylammonium hydroxide and (1-hydroxypropyl)trimethylammonium hydroxide. The formulations may contain bases in any amount or in amounts ranging from 0 to 20 wt% or from 0 to 5 wt %.

When the bases are added to pre-texturing compositions, they are typically used in amounts between from 0 to 10 wt % or between from 0 to 5 wt % based on the total weight of the pre-texturing composition. The pre-texturing composition may comprise between from 0.1 to 15 wt % or between from 0.5 to 10 wt % or between from 1 to 5 wt % base. In some embodiments the pre-texturing compositions are free of or substantially free of bases.

The pH of the pre-texturing compositions may be controlled by adjusting the concentrations of acids and bases. pH may be a factor for controlling surfactant adsorption on the surface of the substrate and thereby the quality of the resulting texturing in the subsequent texturing step.

The pre-texturing compositions of this invention may further comprise one or more chelating agents. The chelating agents may be selected from, but not limited to: ethylenediaminetetracetic acid (EDTA), N-hydroxyethylethylenediaminetriacetic acid (NHEDTA), nitrilotriacetic acid (NTA), diethylklenetriaminepentaceticdiethylenetriaminepentaacetic acid (DPTA), ethanoldiglycinate, citric acid, gluconic acid, oxalic acid, phosphoric acid, tartaric acid, methyldiphosphonic acid, aminotrismethylenephosphonic acid, ethylidene-diphosphonic acid, 1-hydroxyethylidene-1,1-diphosphonic acid, 1-hydroxypropylidene-1,1-diphosphonic acid, ethylaminobismethylenephosphonic acid, dodecylaminobismethylenephosphonic acid, nitrilotrismethylenephosphonic acid, ethylenediaminebismethylenephosphonic acid, ethylenediaminetetrakismethylenephosphonic acid, hexadiaminetetrakismethylenephosphonic acid,
diethylenetriaminepentamethylenephosphonic acid and 1,2-propanediaminetetetamethylenephosphonic acid or ammonium salts, organic amine salts, maronic acid, succinic acid, dimercapto succinic acid, glutaric acid, maleic acid, phthalic acid, fumaric acid, polycarboxylic acids such as tricarbaryl acid, propane-1,1,2,3-tetracarboxylic acid, butane-1,2,3,4- tetracarboxylic acid, pyromellitic acid, oxycarboxylic acids such as glycolic acid, β-hydroxypropionic acid, citric acid, malic acid, tartaric acid, pyruvic acid, diglycol acid, salicylic acid, gallic acid, polyphenols such as catechol, pyrogallol, phosphoric acids such as pyrophosphoric acid, polyphosphoric acid, heterocyclic compounds such as 8-oxyquinoline, and diketones such as α-dipyridyl acetylacetone. The pre-texturing compositions of this invention may contain chelating agents in any amounts or concentrations ranging from 0 wt% to 10 wt% or 0.01 to 10 wt%. In some embodiments the pre-texturing composition is free of or substantially free of chelating agents.

The pre-texturing compositions of this invention may further comprise one or more defoaming agents/anti-foaming agents. The defoaming agents may be selected from, but not limited to: silicones, organic phosphates, ethylene oxide/propylene oxide (EO/PO) based defoamers containing polyethylene glycol and polypropylene glycol copolymers, alcohols, white oils or vegetable oils and the waxes are long chain fatty alcohol, fatty acid soaps or esters. The formulations may contain defoaming agents in any amount or in an amount ranging from 0.0001 wt% to 5 wt % or from 0.001 wt% to 5 wt%. Some compositions, such as some silicone surfactants may function as both defoaming agent and surfactant. An example of a silicon anti-foaming agent is DOW Antifoam 1430. In some embodiments the pre-texturing composition is free of or substantially free of defoaming agents.

The pre-texturing compositions of this invention may further comprise one or more dispersing agents. The dispersing agents may be selected from, but not limited to anionic dispersing agents, nonionic dispersing agents, cationic dispersing agents, and ampholytic dispersing agents; and a polymeric dispersing agent containing an acrylic acid salt as a copolymerized component. Examples of the water-soluble anionic dispersing agents include triethanolamine laurylsulfate, ammonium laurylsulfate, polyoxyethylene alkyl ether triethanolamine sulfate, acrylamido-methyl-propane sulfonate groups for example acrylic acid-2-acrylamido-2-methylpropane sulfonic acid copolymer and mixtures and polycarboxylic acid type polymeric dispersing agents. Examples of the water-soluble nonionic dispersing agents include polyoxyethylene lauryl ether, polyoxyethylene cetyl ether, polyoxyethylene stearic ether, polyoxyethylene oleyl ether, polyoxyethylene higher alcohol ether, polyoxyethylene octyl phenyl ether, polyoxyethylene nonyl phenyl ether, polyoxyethylene derivatives, polyoxyethylene sorbitan monolaurate, polyoxyethylene sorbitan monopalmitate, polyoxyethylene sorbitan monostearate, polyoxyethylene sorbitan tristearate, polyoxyethylene sorbitan monooleate, polyoxyethylene sorbitan trioleate, polyoxyethylene sorbit tetraoleate, polyethylene glycol monolaurate, polyethylene glycol monostearate, polyethylene glycol distearate, polyethylene glycol monooleate, polyoxyethylene alkylamine, polyoxyethylene hardened castor oil, and alkylalkanolamide. Examples of the water-soluble cationic dispersing agents include polyvinylpyrrolidone, coconutamine acetate, and stearylamine acetate. Examples of the water-soluble ampholytic dispersing agents include laurylbetaine, stearylbetaine, lauryldimethylamine oxide, and 2-alkyl-N-carboxymethyl-N-hydroxyethylimidazolinium betaine. The compositions of the invention may contain dispersing agents in any amounts or in an amount ranging from 0 wt% to 5 wt% or from 0 to 3 wt%. In some embodiments the pre-texturing composition is free of or substantially free of dispersing agents.

The pre-texturing composition may comprise other additives, such as sugar or sugar alcohol, such as xylitol, mannose, glucose and the like. The pre-texturing compositions may contain these additives in any amounts or in an amount ranging from 0 wt% to 50 wt% or from 0 to 10 wt%. In some embodiments the pre-texturing composition is free of or substantially free of additives.

The pre-texturing composition may contain oxidizing agents such as nitric acid, peroxides, and hypochlorites in concentrations ranging from 0 to 50 wt% or from 0 to 5 wt%. In some embodiments the pre-texturing composition is free of or substantially free of oxidizing agents.

The pre-texturing compositions may also comprise corrosion inhibitors to protect the process equipment material from corrosion resulting from exposure to the pre-texture treatment compositions. The typical corrosion inhibitors may comprise compounds such as 1,2,4 triazole, amino triazole, benzotriazole, tolytriazole, mercaptobenzothiazole. The pre-texturing compositions may also include corrosion inhibitors such as ascorbic acid which are chemically reducing in nature. In some embodiments the pre-texturing composition is free of or substantially free of corrosion inhibitors.

Typically the pre-texturing composition is an aqueous composition and comprises water as a solvent, such as water, DI water or purified water; however it is possible to use ordinary solvents instead of or in addition to water, including alcohols, glycols, acetone and the like as known to a person of skill in the art. Typically the pre-texturing compositions comprise greater than 1 wt % or greater than 30 wt %, or greater than 50 wt% or greater than 70 wt % or between 1 to 99.9 wt% water or from 50 and 95 wt % or between from 80 and 99 wt % water based on the total weight of the compositions. Typically the pre-texturing compositions comprise, consist of, or consist essentially of one or more surfactants and water (deionized water) or one or more surfactants and/or one or more acids and/or one or more bases and/or one or more defoaming agents and/or other additives and the balance is water (deionized water). Typically the pre-texturing compositions comprise, consist of, or consist essentially of one or more surfactants and water (deionized water) or one or more surfactants and/or one or more acids and/or one or more bases and/or one or more defoaming agents and/or other additives and the balance is water (deionized water). One embodiment of the pre-texturing composition of the invention comprises one or more surfactants (for example, 0.5 to 5 wt%, (useful wt% of the surfactants and other components were listed earlier), one or more organic acids (for example, 0.01 to 5 wt %), one or more optional bases (for example, 0 to 5 wt %), one or more optional anti-foaming agents (for example, 0 to 0.5 wt%) and one or more optional corrosion inhibitors (for example, 0 to 2 wt %) and the balance is water (up to 99 wt %).

In some embodiments, the pre-texturing compositions of this invention and/or any etching composition used in the method of the invention is free of or substantially free of isopropyl alcohol (IPA). In some embodiments, the pre-texturing and/or texturing compositions used in this invention are free of or substantially free of dihydric and polyhydric alcohols. In some embodiments, the pre-texturing and/or texturing compositions used in this invention are free of or substantially free of alcohols. In some embodiments, the pre-texturing and/or texturing compositions are free of or substantially free of fluorine containing surfactants.

The wafers are wetted by the pre-texturing composition of this invention, and by the texturing compositions. The wafers may be wetted by flooding, spraying, immersing, or other suitable manner. In some cases, agitation of the pre-texturing composition and/or the texturing composition is needed to assure that the composition is always in intimate contact with the surface of the substrate during the texturing process.

The texturing process of this invention may be a multi-step texturing process comprising at least a pre-texturing step followed by a texturing step. The multi-step texturing process may also comprise one or more rinse steps, one or more cleaning steps, one or more optional saw damage removal steps, and/or other steps. The wafer may be wetted with the pre-texturing composition of this invention either before a saw damage removal step or before the texturing (etching) step or before both of the saw damage removal and the texturing step. In certain cases, the wafers may undergo texturing after pre-texturing step of this invention without having any saw damage removal step in the processing sequence. Presently the pre-texturing treatment as the step just before (the step prior to) the texturing step, with a rinse step between, appears to be the most effective in terms of improving the quality and speed of the texturing step for wafers. Using compositions of this invention for pre-texturing treatment step can also reduce the time required to achieve complete texturing on the surface.

The wafers may be rinsed in separate rinsing steps before and after the pre-texturing and/or texturing steps. The wetting may be done at room temperature or elevated temperature, for example from 0°C to 110°C or 10 to 90°C for any of the steps in the texturing process. The wafer may be wetted with the pre-texturing composition of this invention for a time that may vary based on the method by which the pre-texturing composition of this invention is applied to the wafer. Typically, a single wafer processing on a conveyor belt through the texturing process has a shorter treatment time as compared to a batch scale immersion texturing process. The pre-texturing step and/or texturing step could each be in the range of 1 second to an hour. Preferred pre-texturing step or texturing step times may be between 20 seconds and 30 minutes. The times for the pre-texturing and/or texturing steps may be reduced by increasing the temperature of the texturing baths used for each of those steps.

Examples of such standard texturing compositions (etching compositions) used to roughen or etch the substrate have been disclosed in the prior art and are known to a person of skill in the art. Some examples of known texturing compositions will be described below. The standard texturing composition used in the texturing step of this invention may be substantially free of surfactant. Substantially free of surfactant means less than 0.0001 wt% of surfactant. A texturing composition may be surfactant-free when it is formulated; however, some surfactant may be introduced to the texturing bath from the wafer when the wafer with residual surfactant thereon from the pre-texturing step of this invention is wetted with the texturing composition.

Etching compositions may be any composition that provides the desired reflectance of the one or more surfaces of the wafer. The etching compositions may be alkaline or acidic etching compositions. Alkaline etching compositions are typically used for monocrystalline wafers and acidic etching compositions are typically used for multicrystalline wafers. Acidic etching compositions comprise one or more acids in a solvent and may comprise one or more of the following: HF, HNO₃, and H₄PO₃, carboxylic acids, e.g. acetic acid, and other acids or mixtures of acids, such as those described above as useful in the pre-texturing composition. The traditional texturing solution for multi-crystalline silicon is the isotropic etching comprising an acid mixture comprising one or more acids selected from the group consisting of HF and HNO₃. Alternatively or additionally the texturing composition may comprise any of the inorganic or organic acids and/or oxidizing agents described above as useful in the pre-texturing composition of this invention. In one embodiment of the method of this invention, an alkaline or acidic rinse follows the texturing step using a texturing composition. Typically the acidic etching solution may have a concentration between about 5 weight percent and about 70 weight percent of acid or mixtures of acids in solvent, such as deionized water (DI) or water. The etching compositions or texturing (etching) compositions may be alkaline etching compositions. Examples of alkaline etching compositions include those comprising one or more hydroxides in solvent. The one or more hydroxides may be selected from the group of potassium hydroxide (KOH), sodium hydroxide (NaOH), ammonia (NH₄OH), tetramethylammonium hydroxide (TMAH; or (CH₃)₄NOH), or other similar basic components in solution, typically in water. Alternatively or additionally, the alkaline etching compositions may comprise the bases described above as useful in the pre-texturing composition. The alkaline solution may have a concentration between about 0.1 weight percent and about 15 weight percent of KOH or other hydroxide in deionized water (DI) water. The alkaline or acidic etching solutions may also contain one or more additives, such as, chelating agents, defoamers, dispersants, to improve texturing of silicon surfaces. A list of additives known to improve the texturing include alcohols (e.g. isopropyl alcohol (IPA)) and polyethers including polypropylene glycol (PPG), copolymer of polyethylene glycol (PEG), tetraethylene glycol, poly(4-vinylphenol) (PVP), brominated poly(4-vinyl phenol), polystyrene sulfonic acid (PSSA), Joncryle polymers (empirical formula C₃H₄O₂), phenol (C₆H₅OH), ortho-cresol (o-cresol), meta-cresol (m-cresol), and para-cresol (p-cresol), poly(cresol), hydrocolloids, such as starch, cellulose, pectin, gelatin, and xanthan gum. The concentration of the additive may vary from 0-25 wt% of the texturing solution.

This invention is not limited by the etching composition and any known etching composition may be used in the texturing step following the pre-texturing step of this invention.

Regarding the rinsing step, excessive rinsing may reduce the effectiveness of the pre-texturing composition of this invention in increasing pyramid density (for monocrystalline wafers) and improving the texturing quality (for multicrystalline wafers) in the later texturing (etching) step in the texturing process. Inadequate rinsing on the other hand may leave behind thick chemical residues on the surface and/or chemical cross-contamination into the texturing bath, which may hinder the chemical reactions of the silicon surface during the texturing surface resulting in poor texturing. Rinsing conditions may have to be optimized for a particular composition, process tool and process conditions to achieve good results. Various kinds of rinsing techniques may be used to wet the wafer. Examples include spraying the rinse composition onto the wafer surface, immersion in an overflow rinse tank, and quick-dump-rinse (QDR) cycling in a rinse tank that may be in a wet bench tool.

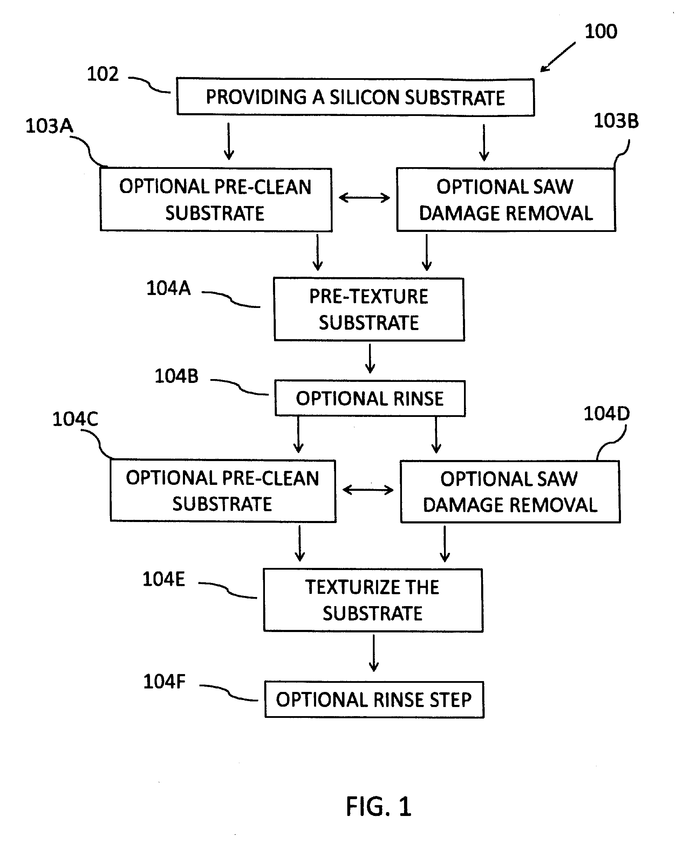

FIG. 1 depicts a flow diagram of one embodiment of a surface texturing process sequence 100 suitable for performing on a silicon substrate. Although the process sequence 100 is illustrated for solar cell manufacturing process, the process sequence 100 may be beneficially utilized to form textured surfaces suitable for other structures and applications. In one embodiment, the process sequence 100 discussed below is performed in an automated production line that has a robotic device that is adapted to transfer each of the processed substrates to a series of processing baths that are adapted to perform all of the processing steps discussed below. While not shown in FIG. 1, alternative embodiments of the process sequence 100 may include additional steps, for examples, drying steps and/or additional rinsing steps between each of the processing steps discussed below. The additional rinsing steps prevent over exposure to the processing chemistry during each step and reduce the chance of cross-contamination, for example due to chemical carryover, between adjacent processing baths. In the embodiment shown in FIG. 1, the texturing process comprises a pre-texturing step 104A and a texturing step 104E, and other optional steps. The steps of the invention described below may include means to agitate the compositions used in each step.

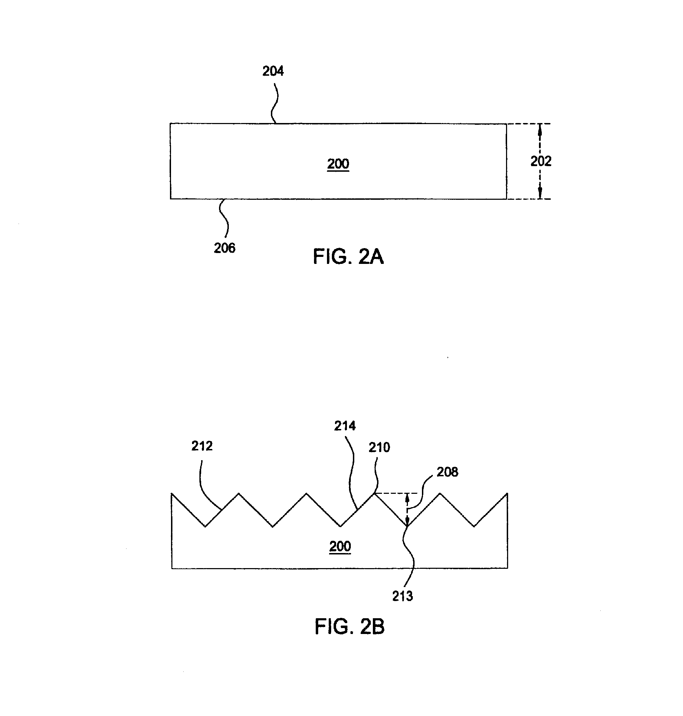

The process sequence 100 begins at step 102 by providing a silicon substrate 200 having an upper surface 204 and a bottom surface 206, as depicted in FIG. 2A. The substrate 200 may have a thickness 202 between about 100 µm and about 400 µm. In one embodiment, the substrate 200 may be a monocrystalline substrate (e.g., Si<100> or Si<111 >), a microcrystalline silicon substrate, a polycrystalline silicon substrate, a strained silicon substrate, an amorphous silicon substrate, a doped or undoped polysilicon substrate, glass, sapphire or any type of silicon containing substrate. In the embodiment wherein the substrate 200 is desired to be an n-type crystalline silicon substrate, donor type atoms are doped within the crystalline silicon substrate during the substrate formation process. Suitable examples of donor atoms include, but not limited to, phosphorus (P), arsenic (As), antimony (Sb). Alternatively, in the embodiment wherein a p-type crystalline silicon substrate is desired, acceptor type atoms may be doped into the crystalline silicon substrate during the substrate formation process.

At steps 103A and 103B, the substrate 200 is optionally pre-cleaned and/or optionally treated for saw damage removal prior to performing the texturing process (e.g., steps 104A-F). Step 103B may be performed before 103A and vice-versa or alternatively a single step (not shown) may be used to clean and remove the saw damage. In alternative embodiments (not shown), the pre-clean process is a multi-step process that is used to remove unwanted contamination, surface damage and/or other materials that could affect the subsequent processing steps. In one embodiment, in step 103A, the pre-clean process may be performed by wetting the substrate with an acid solution and/or solvent to remove surface particles, native oxide or other contaminants from the substrate. The pre-clean solution may be a hydrogen fluoride (HF) aqueous solution having a mixture of hydrogen fluoride and deionized water at a ratio between about 0.1:100 to about 4:100. In one embodiment depicted herein, the pre-clean solution is a hydrogen fluoride (HF) aqueous solution having a concentration between about 0.1 weight percent and about 4 weight percent, such as between about 1 weight percent and about 2 weight percent HF and the balance is deionized water (for example, up to 99.9 wt %). The cleaning solution may comprise ozonated DI water having between about 1 ppm-30 ppm of ozone disposed in DI water. The pre-clean process may be performed on the substrate between about 5 seconds and about 600 seconds, such as about 30 seconds to about 240 second, for example about 120 seconds. The pre-clean solution may also be a standard cleaning solution 1 (SC1), a standard cleaning solution 2 (SC2), or other suitable and cost effective cleaning solution may be used to clean a silicon containing substrate. (SC1 consists of NH₄OH (28 wt%), H₂O₂ (30 wt%) and deionized water, the classic formulation is 1:1:5, typically used at 70°C; however, it may comprise a higher ratio of water. SC2 consists of HCl (73 wt%), H₂O₂ (30 wt%), deionized water, originally developed at a ratio of 1:1:5, typically used at 70°C; however, it may comprise a higher ratio of water.) In one example, the pre-clean process includes immersing the substrate in an aqueous solution comprising 2% by volume hydrofluoric acid (HF), at room temperature for a time of between about 1 to 3 minutes. In another example, the pre-clean process includes immersing the substrate in a HN type solution comprising 3% by volume nitric acid (HNO₃) and 5% by volume hydrofluoric acid (HF), balance DI water, at room temperature for a time between about 2 and about 10 minutes. In one example, a 10 minute cleaning and saw damage removal process using the HN solution was used to remove gross amounts of wafer sawing contamination prior to performing the texturing process (steps 104A-F). The use of the HN cleaning process decreases Cr, Cu, Fe, and Ni contamination as compared to sawed and water rinsed substrates (See WO 2009/120631 A2). After performing the HN cleaning process the substrate may be rinsed in a mixture of 0.5% isopropyl alcohol (IPA) and DI water. (The rinse step is not shown.)

In one embodiment a saw damage removal process (step 103B) is performed to remove any physical damage created by the previous sawing process. In one embodiment, the saw damage removal process step 103B is performed after performing an acid etching step 103A, such as the HN cleaning process discussed above, and before performing steps 104A-F. In one embodiment, the saw damage removal process may include etching the substrate in a saw damage removal bath comprising between about 5% and 45% by volume of potassium hydroxide (KOH) and the balance DI water. In one example, the saw damage removal process may include etching the substrate for about 22 minutes in a saw damage removal bath consisting of 20 vol. % of KOH in deionized water maintained at 70°C. In another example, the saw damage removal process includes etching the substrate for about 10 minutes in a saw damage removal bath consisting of 20 vol. % of KOH in deionized water maintained at 80°C. After performing the saw damage removal process the substrate is typically rinsed in warm DI water for, for example, 3 minutes (this step is not shown in Figure 1). In another example, the saw damage removal process may include wetting the substrate for about 45 seconds in a saw damage removal bath comprising 45 vol. % of KOH in deionized water maintained at 65°C.

At step 104A, the first step of the texturing process, the substrate 200 is wetted by the pre-texturing composition of this invention comprising surfactant in a pre-texturing step. The substrate 200 may be wetted by flooding, spraying, immersion, or other suitable manner. The wetting may take place in a bath. Examples of suitable pre-texturing compositions were described above and include those disclosed in the examples below. The wetting may be done at room temperature or elevated temperature, for example from 0°C to 150°C or 10 to 120°C or 30 to 110°C. The time for wetting will vary with the various methods and in the case of a pre-texturing bath may vary for a single wafer as opposed to batch scale immersion method. The treatment time could be in the range of 1 second to 1 hour. Preferred treatment times for the pre-texturing step may be between 20 seconds and 30 minutes, or 1 minute to 15 minutes.

The surface of the wafer after the pre-texturing step is typically not changed by the pre-texturing composition. If the wafer has a substantially smooth surface prior to being wet with the pre-texturing composition, then it should have a substantially smooth surface after the pre-texturing step, with no substantial change in the texture. For example, typically no substantial change in reflectivity will result from the pre-texturing step until the wafer is wet with the texturing (etching) composition. A substantially smooth surface means that less than 10%, less than 5%, or less than 2% of the surface of the substrate is roughened or covered with pyramids. After the pre-texturing step 104A is an optional rinse step 104B. The rinse step typically comprises wetting the substrate with water or DI water; however the rinse composition may also comprise small amounts of additives (e.g. acids, bases, chelating agents, defoaming agents, corrosion inhibitors, etc) described earlier. The rinse step is used to prevent chemical carryover from the pre-texturing bath to a later step in the process. The rinse step typically comprises immersion of the substrate in a bath of water or DI water for 10 minutes or less or 5 minutes or less. The necessity for and the time for the rinse step will depend on several factors related to the pre-texturing step and the steps that may or may not follow the rinse step 104A. Regarding the pre-texturing step, the higher the weight percent of surfactant in the pre-texturing composition and the longer the contact time between the substrate and the pre-texturing composition or greater the temperature during the pre-texturing step, the greater the need for a rinse step. Further, the time required for the rinse step may be more or less, depending upon factors such as the agitation of a rinse bath and/or the addition of cleaning agents or the like in the rinse composition. If one or more of the optional pre-clean and/or saw damage removal steps 104C and/or 104D follow the texturing step 104A, then in some embodiments the rinse step 104B may be eliminated from the process. The one or more optional pre-clean and/or saw damage removal steps 104C and/or 104D will result in the removal of any carryover chemicals.

In some embodiments that do not have a separate pre-clean step 103A and/or saw damage removal steps 103B, the pre-texturing step 104A may perform one or more of those additional functions as well as wet the surface of the substrate with the pre-texturing composition and later with the texturing composition for the purpose of roughening (texturing) the surface in the subsequent texturing step. The formulation of the texturing composition used in step 104A may be used as-is or adjusted to provide a formulation that can provide improved cleaning and/or saw damage removal and/or the pre-texturing in the pre-texturing step.

In some embodiments the texturing process may comprise optional pre-clean and/or optional saw damage removal steps prior to performing the texturing process (e.g., steps 104A-F). One or more of steps 104C and 104D may be in addition to or in alternative to one or more of steps 103A and 103B which may be performed before the pre-texturing step. As above for steps 103A and 103B, step 104D may be performed before 104C and vice-versa or a single step (not shown) may be used to clean and remove the saw damage. Everything stated above for the steps 103A and 103B applies to steps 104C and 104D, respectively as if it were repeated here.

In optional embodiments, an additional pre-texturing step (not shown) may follow steps 104C and/or 104D. (If both steps 104C and 104D are present in the texturing process, step 104C may follow or precede step 104D). In one embodiment, the texturing process may comprise the steps of wetting the substrate with a pre-texturing composition, wetting the substrate with a saw damage removal composition, and wetting the substrate with a texturing (etching) composition. That embodiment may further comprise one or more steps of rinsing the substrate with a rinse composition. The rinse steps may occur before and/or after one or more or all of the steps. That embodiment may also comprise an additional step of wetting the substrate with a pre-cleaning composition prior to the pre-texturing step.

At step 104E, the substrate 200 is wetted by a texturing (etching) composition. The etching composition is any etching composition and can be a standard or otherwise known etching composition. The etching composition or texturing (etching) composition is used to roughen, etch or texture, at least one surface of the substrate. The substrate 200 may be wetted by flooding, spraying, immersion, or other suitable manner. In some cases, agitation of the texturing composition is needed to assure that it is always in intimate contact with the surface of the substrate during the texturing process. In the case of monocrystalline wafers, the texturing composition will anisotropically etch the substrate 200, thereby providing a textured surface 212 of the substrate 200, as depicted in FIG. 2B. As a result, the substrate 200 is etched to form pyramids 214 on the textured surface 212. It is noted that the texturing (etching) composition may etch both upper surfaces 204 and bottom surface 206 of the substrate 200. The textured surface may be formed on one or both sides of the substrate 200. The roughness of the textured surface 212 may be determined by the shape, height, dimension and depth of the pyramid 214 formed on the textured surface 212. In general, the average height is defined as the average difference between the peak 210 to valley 213, as measured over an area or region of the substrate surface. In general, the average height is defined as the average difference between the peak 210 to valley 213, or average height, as measured over an area or region of the substrate surface by use of a mechanical profilometer, optical profilometer or other optical inspection techniques (e.g., confocal microscopy, 3D-SEM image). A comparable value the nominal height was measured for the examples. The nominal height was measured by using of a 2-D cross-sectional SEM image. By visual inspection the pyramid height represented by the majority of pyramids in the cross-section was used to measure the nominal pyramid height. In some embodiments, the average height 208 of the pyramids was between from about 0.5 µm to about 10 µm, for example, from between about 1 µm to about 8 µm, or from about 1 to about 5 µm. In other examples, the average height 208 of the pyramids was between from 0.5 to about 3 µm from the pyramid apex, or peak 210, to its valley 213. For multicrystalline silicon, the surface roughness will be increased and the reflectance will be decreased.

The etching composition or texturing (etching) composition may be any composition that is effective at texturing the substrate surface, including any known texturing solutions, in most embodiments aqueous solutions. In one embodiment, the texturing composition is an alkaline solution that may have one or more other additives therein and is maintained at a temperature between about 50°C and about 95°C. In another embodiment, the alkaline solution for etching the silicon substrate may comprise an aqueous potassium hydroxide (KOH), sodium hydroxide (NaOH), aqueous ammonia (NH₄OH), tetramethylammonium hydroxide (TMAH; or (CH₃)₄NOH), or mixtures of those, or other similar aqueous basic solution. The alkaline solution may have a concentration between about 1 weight percent and about 15 weight percent of KOH or other hydroxide or mixture of hydroxides in deionized water (DI) water, or about 3 weight percent KOH or other hydroxide or mixture of hydroxides in DI water. Most alkaline texturing solutions comprise greater than 50% water, or between from 50 to 99% water or between from 70 to 98 wt% water.

The texturing (etching) composition may comprise acids such as HF and an oxidizer. These kinds of solutions are known to be very effective for texturing multi-crystalline silicon surfaces. The most common oxidizer used is nitric acid. The texturing solution may also comprise other additives such as carboxylic acids, mineral acids, water and other additives. Most common additives include acetic acid, phosphoric acid, sulfuric acid. Most acidic texturing solutions comprise between from 1 to 70 wt% water or between from 5 to 50 wt% water. Example texturing formulations may comprise 5 wt% to 70 wt% water, 5 wt% to 60 wt% hydrofluoric acid and 2 wt% to 60 wt% nitric acid (or another suitable oxidizer) and 0-50 wt% of one or more additives. Texturing may be performed by exposing the multicrystalline silicon piece for 10 seconds to 10 minutes in the etching solution at a temperature from 0 to 40°C. It is known that by lowering the temperature better results may be obtained.

In other embodiments the texturing (etching) composition may comprise additives that are added thereto. Other additives include wetting agents that may be selected from a group of materials, such as alcohols (IPA) and polyethers including polypropylene glycol (PPG), copolymer of polyethylene glycol (PEG), tetraethylene glycol, and combination thereof, derivatives thereof, and the like. The components of the texturing composition may be selected to have a high boiling point/flash point and high solubility, thereby preventing the wetting agent from igniting, evaporating or precipitating during the process.

In one embodiment of the texturing (etching) composition, the one or more surface modification additives that are added to the texturing composition comprise a wetting agent and an etching additive. In general, the additive is selected so that it will modify the texturing process on the surface of the substrate, such as accelerating or inhibiting the etch rate across the surface of the substrate to minimize localized variations in etch rate and improve the uniformity of the formed texture. The wetting agent also prevents the dissolved elements etched away from the substrate surface from being reattached to the substrate surface. In one embodiment, the etching additive is a phenol based material. In one example, the etching additive is a material, such as poly(4-vinylphenol) (PVP), brominated poly(4-vinyl phenol), polystyrene sulfonic acid (PSSA), Joncryle polymers (empirical formula C₃H₄O₂), phenol (C₆H₅OH), ortho-cresol (o-cresol), meta-cresol (m-cresol), and para-cresol (p-cresol), poly(cresol), combination thereof, derivatives thereof, and the like.

Additional additives that the texturing (etching) composition may comprise include hydrocolloids, such as, starch, cellulose, pectin, gelatin, and xanthan gum to improve the texturing performance of the composition. Texturing compositions may also or alternatively comprise the acids and/or bases, and the salts thereof, corrosion inhibitors, oxidizing agents, defoaming agents, chelating agents and other additives described above for the pre-texturing compositions of the invention, for some embodiments, at the amounts described above for the pre-texturing compositions.

Examples of the texturing (etching) compositions comprise aqueous potassium hydroxide (KOH) solutions containing a PEG compound. The PEG is added to the alkaline solution in an amount between about 20 ppm and about 50,000 ppm.

The texturing or etching composition for monocrystalline silicon etching is typically heated during etching to a temperature between about 50°C and about 95°C, or between from about 75°C to about 85°C, such as about 80°C. The texturing (etching) composition for multicrystalline silicon is typically operated at 0 to 40°C. The texturing process comprising the pre-texturing step and the texturing step using a texturing (etching) composition with optional rinse and/or clean and/or saw damage and/or other steps may be performed between about 1 minute to about 90 minutes, such as between about 15 minutes and about 60 minutes, such as about 30 minutes and about 40 minutes. The pre-texturing step as stated above may range from 1 second to one hour or between 20 seconds and 30 minutes. The texturing step may range from 5 minutes to 30 minutes or 10 minutes to 30 minutes. Additional steps that are part of the texturing process, such as, one or more rinse steps before and/or after the pre-texturing step and the texturing step may each take between from 15 seconds to 10 minutes or between from 1 minute to 5 minutes. Additional cleaning or saw damage removal steps that may be part of the texturing process may each take from 1 minute to 15 minutes or from 5 minutes to 10 minutes. In one embodiment, a pre-texturing step is performed using a pre-texturing composition of this invention (comprising a surfactant) followed by a texturing step using an etching composition that is free of or substantially free of the surfactant used in the pre-texturing step, or that is free of or is substantially free of the surfactants used in any of the compositions of this invention that are listed herein, or that are free of or substantially free of any surfactants. In some embodiments, the etching composition is free of or substantially free of wetting agents and/or additives.

In one example, the substrate is etched in a texturing composition comprising 4 wt% potassium hydroxide (KOH) and 2 wt% isopropanol (IPA), balance water at 80°C for 5 to 30 minutes. Other texturing compositions comprise about 2-5% by volume of potassium hydroxide (KOH), balance water, that is maintained at a temperature of about 79-80°C for about 30 minutes that may or may not comprise additives.

Since surface texturing uniformity and surface roughness results have a large effect on the solar cell electrical performance, the control and optimization of the processing results and uniformity across the surface of the substrate are important factors in the formation of a solar cell device. Embodiments of the invention described herein may utilize a texturing process free of or substantially free of volatile additive such as isopropyl alcohol; to reduce the processing cost, improve process results, reduce process variation, and reduce the fire and safety concerns associated with the use of alcohols. Alternatively, the texturing process may be substantially alcohol free, meaning that the compositions used in the texturing step comprise less than 1wt% or less than 0.5wt% alcohol, for example IPA. It is believed that the use of a pre-texturing step (step 104A) may reduce the requirements of alcohol for the texturing step (step 104E) and/or may reduce the processing time needed for the texturing step, in some cases by about 50% or more over conventional processes that do not use the pre-texturing step of this invention.

Also, it has been found that, when applied to monocrsytalline silicon substrate, the pre-texturing composition of this invention and/or the texturing process comprising the pre-texturing step described herein will generally provide a larger number of smaller random pyramids per unit area on a single crystal solar substrate, that are uniformly spread over the surface of the substrate while providing improved reflectance results as compared to a conventionally textured substrate. The increased number of smaller formed pyramids is an advantage since the variation in pyramid size and density variation of the pyramids is reduced over conventionally formed textures. It is believed that the pre-texturing composition and step provides texturing compositions that generally promote the uniform initiation of the texturing process thus providing a more uniform texture across the substrate surface.

After the texturing step 104E is complete, there may be performed an optional rinse step 104F, for example, water rinse step as described above and/or a drying step (not shown) may be performed to remove some, most or substantially all of the texturing (etching) composition from 104E and any other residual chemicals from the substrate surface. The drying process may include drying the substrate with a flow of nitrogen gas, or a flow of clean dry air.

After the texturing process (step 104) is performed on the substrate surface, the substrate reflectance is decreased by about 40 to 60 percent or more.

The following examples illustrate the pre-texturing compositions and methods of this invention.

### Examples

The processing for the following Examples 1-4 was done on monocrystalline wafer pieces. Rectangular pieces in the size range of 3 to 5 cm each side were processed in a 600 ml glass beaker with 600 RPM agitation with a stir bar. Four pieces were used for each process and the data reported is an average for the four pieces. Pieces were clamped vertically in the beaker using a fixture which also served to cover the beaker lid. Unless otherwise indicated, rinsing was performed by overflow rinse using a DI water flow rate of approximately 100 ml/min. If a temperature is not specified for a step, the temperature was room temperature. If only part of a composition is specified herein, the balance was DI water.

### Example 1

As-cut monocrystalline solar grade wafers were obtained from two different sources. These wafers were treated in various process sequences to achieve texturing on the surface.

In some of the processes of the examples, wafers were treated with a solution, herein referred to as **Formulation 1** consisting of 4 wt% oxalic acid and 1.5 wt% Hostapure SAS (purified by ion exchange) and the balance DI water.

Three different texturing processes were used to process the wafer pieces. The three different processes (A, B and C) were as follows with the process steps labeled (i, ii and iii, etc) in the order in which they occurred:

Process A: (i) Saw damage removal in 20 wt% KOH solution (balance DI water) for 10 min at 80°C; (ii) 3 min DI water rinse; (iii) texturing in a solution containing 4 wt% KOH and 2 wt% Isopropanol (IPA) (balance DI water) for 20 minutes at 80°C; and (iv) 3 minute DI water rinse.

Process B: (i) Immersion in Formulation 1 for 5 minutes at 50°C; (ii) 3 min DI water rinse (iii) Saw damage removal in 20 wt% KOH solution for 10 min at 80°C; (iv) 3 min DI water rinse; (v) texturing in a solution containing 4 wt% KOH and 2 wt% Isopropanol (IPA) (balance DI water) for 20 min at 80°C; and (vi) 3 minute DI water rinse.

Process C: (i) Saw damage removal in 20 wt% KOH solution for 10 min at 80°C; (ii) 3 min DI water rinse; (iii) Immersion in Formulation 1 for 5 minutes at 50°C; (iv) 3 min DI water rinse (v) texturing in a solution containing 4 wt% KOH and 2 wt% Isopropanol (IPA) (balance DI water) for 20 min at 80°C; and (vi) 3 minute DI water rinse.

After the texturing processes, the reflectance was measured on each of the wafers using an integrated sphere tool (Perkin-Elmer Lambda 900). Average-weighted reflectance was calculated in the wavelength range of 300 to 830 nm. Spectral irradiance data for the calculations of average weighted reflectance was obtained from R. Hulstrom, R. Bird, and C. Riordan, "Spectral solar irradiance data sets for selected terrestrial conditions," Solar Cells, vol. 15, pp. 365-391. Table 1 summarizes the reflectance data for the wafers from the two sources after the processing with Process A, B or C. Based on an SEM of the cross-section of each wafer the nominal pyramid height was measured using the most represented height of the pyramids present in the cross-section.

**Table 1**

| | Source 1 Wafers | | | Source 2 Wafers | | |
|---|---|---|---|---|---|---|
| Process Sequence | Average Reflectance % | Standard deviation for Reflectance | Nominal Pyramid Height (µm) | Average Reflectance % | Standard deviation | Nominal Pyramid Height (µm) |
| A | 14.25 | 0.03 | 9.9 | 20.37 | 2.48 | 13.4 |
| B | 13.54 | 0.11 | 4.2 | 12.39 | 0.28 | 4.4 |
| C | 13.57 | 0.34 | 1.6 | 12.99 | 0.62 | 1.9 |

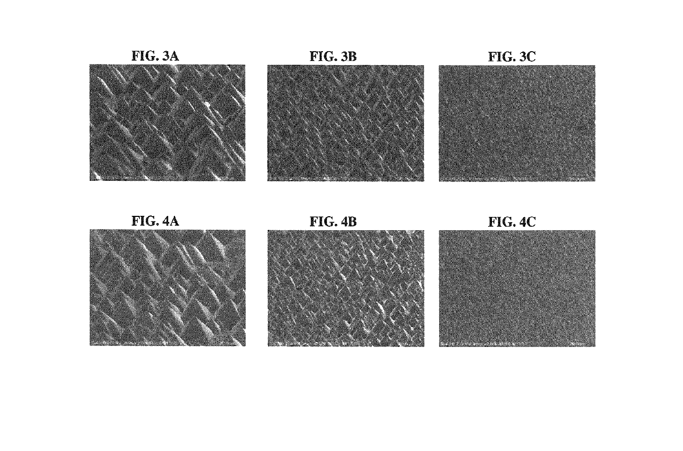

Scanning electron micrographs (SEMs) of the textured wafers produced by Processes A, B and C were taken at a 65° tilt angle. The wafers from the first source treated using Processes A, B and C are shown in FIG. 3 A, B and C, respectively. The wafers from the second source treated using Processes A, B and C are shown in FIG 4 A, B and C, respectively.

It is evident from the table and the SEM pictures, that the wafers treated with Formulation 1 result in lower reflectance and lower pyramid height. The table and micrographs show that for the tests performed above, the best results were obtained when the treatment with Formulation 1 is performed just before texturing step.

### Example 2

As-cut monocrystalline wafers obtained from the third source were processed using Process C described for Example 1 except that the various pre-texturing formulations in Table 2 were substituted for Formulation 1 in Example 1. (Formulation 1 from Example 1 has been included in Table 2 also.)

**Table 2**

| Formulation # | Oxalic Acid | Hostapur SAS | Water (wt%) |
|---|---|---|---|
| | Concentration (wt%) | (Purified acid form) | |
| | | (wt%) | |
| 1 | 4 | 1.5 | 95.5 |
| 2 | 4 | 0 | 96 |
| 3 | 0 | 1.5 | 98.5 |
| 4 | 0.8 | 0.3 | 98.9 |
| 5 | 0.4 | 0.15 | 99.45 |

Table 3 summarizes the average reflectance percentages and the nominal pyramid heights of the wafers from Example 2 and includes the data for Formulation 1 from Example 1 also.

**Table 3**

| Formulation # | Average Reflectance (%) | Nominal Pyramid height |
|---|---|---|
| | | (µm) |
| 1 | 12.99 | 1.9 |
| 2 | 15.67 | 13.45 |
| 3 | 12.11 | 4 |
| 4 | 12.63 | 5.75 |
| 5 | 13.13 | 11.77 |

This example shows that the presence of the surfactant in the pre-texturing composition reduces reflectance and pyramid height and that more than 0.15 wt% surfactant in the pre-texturing composition may be more preferred for some embodiments.

### Example 3

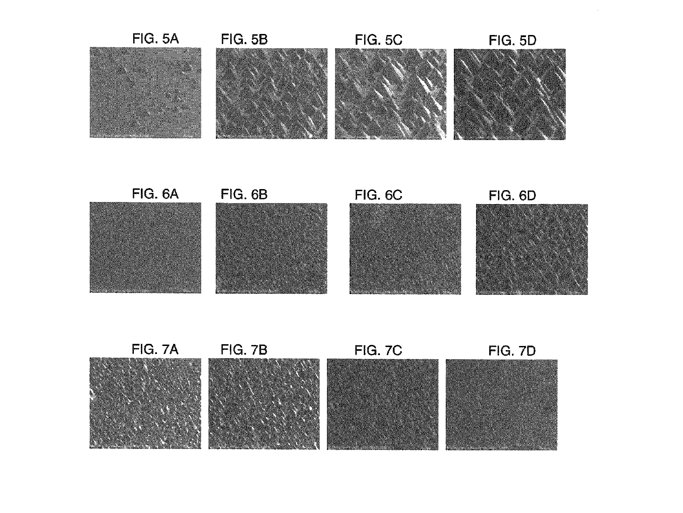

In order to study the effect of texturing time on pyramid structures the wafers from the second source were treated using Processes A, B and C; however, the texturing times for the wafers were varied. The texturing times used were 5 minutes, 10 minutes, 15 minutes and 20 minutes for each. SEMs were taken of representative of the wafers at a 65° tilt angle treated using each of the texturing times in each Process. The SEM for the wafer treated using Process A with a 5 minute texturing step is shown in FIG 5A. The SEM for the wafer treated using Process A with a 10 minute texturing step is shown in FIG 5B. The SEM for the wafer treated using Process A with a 15 minute texturing step is shown in FIG 5C. The SEM for the wafer treated using Process A with a 20 minute texturing step is shown in FIG 5D. The SEM for the wafer treated using Process B with a 5 minute texturing step is shown in FIG 6A. The SEM for the wafer treated using Process B with a 10 minute texturing step is shown in FIG 6B. The SEM for the wafer treated using Process B with a 15 minute texturing step is shown in FIG 6C. The SEM for the wafer treated using Process B with a 20 minute texturing step is shown in FIG 6D. The SEM for the wafer treated using Process C with a 5 minute texturing step is shown in FIG 7A. The SEM for the wafer treated using Process C with a 10 minute texturing step is shown in FIG 7B. The SEM for the wafer treated using Process C with a 15 minute texturing step is shown in FIG 7C. The SEM for the wafer treated using Process C with a 20 minute texturing step is shown in FIG 7D.

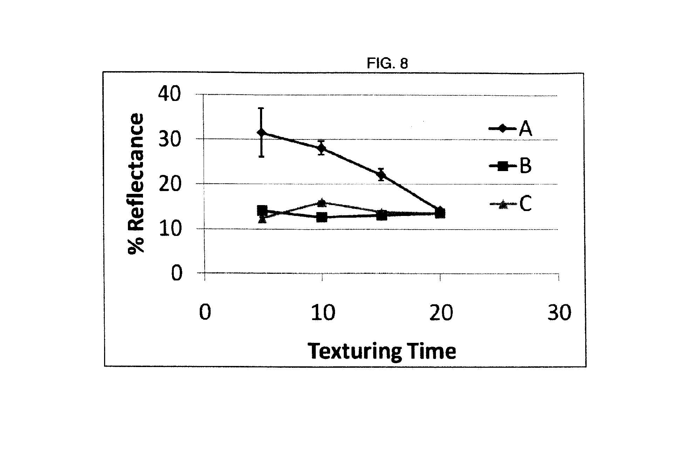

Figure 8 shows a graph of the percent reflectance versus the texturing times for the wafers treated using Processes A, B and C of this example.

The micrographs and the graph show that in the absence of exposure to a pre-texturing composition of this invention (for example Formulation 1), the texturing time to achieve a low reflective surface increases. Exposure to Formulation 1 in either Process B or Process C, leads to lower percent reflectance quicker. The SEM pictures show that for Process A, (FIG. 5A-D) it takes longer time to nucleate pyramids over the entire surface. The wafer pieces exposed to Formulation 1, on the other hand shown in FIG 6A-D and 7A-D show pyramids covering the entire surface in shorter texturing times. It is presently believed that the surfactant in the pre-texturing composition modifies the surface of the wafer which promotes nucleation of pyramids during texturing process.

### Example 4

A number of surfactants were used in the pre-texturing compositions of this invention. For this Example, Process D was used: (i) as-cut monocrystalline wafer pieces were etched in 20% KOH solution for 10 min at 80°C; (ii) rinsed for 3 minutes; (iii) the pieces were immersed at room temperature for 5 minutes in various pre-texturing compositions (identified as Formulations in Table 4), each of which contained 1.5 wt% of the Surfactants shown in Table 4; (iv) the pieces were rinsed with DI water for 3 minutes using overflow rinse; and (v) the pieces were then treated with 4% KOH solution at 80°C. The average reflectance was measured. The lower the reflectance, the better the texturing.

**Table 4**

| Formulation # | Surfactant | Average Reflectance (%) | Standard Dev. |
|---|---|---|---|
| 6 | Tergitol 15-S-7 | 31.12 | 4.75 |
| 7 | Triton X-1 00 | 31.99 | 3.89 |
| 8 | Tergitol NP-9 | 32.79 | 4.26 |
| 9 | Tergitol TMN-6 | 31.58 | 2.08 |
| 10 | Calfax DBA70 | 35.63 | 1.99 |
| | Purified Hostapur SAS (1.5%)+ Dynol | | |
| 11 | 604 (0.5%) | 26.58 | 3.75 |
| | Purified Hostapur SAS | | |
| 12 | (1.5%)+Surfynol 2502 (0.5%) | 27.32 | 2.46 |
| | Polyethylene Glycol (Molecular | | |
| 13 | weight 300) | 36.72 | 0.63 |
| 14 | Empigen BB | 37.02 | 0.82 |
| 15 | Surfynol 485 | 27.94 | 1.88 |
| 16 | Surfynol 465 | 36.73 | 0.58 |
| 17 | Tomadyne 102 | 38.07 | 0.61 |
| 18 | 1-Octanesulfonic acid | 37.63 | 0.36 |
| | Polyethylene Glycol (Molecular | | |
| 19 | weight 1500) | 27.83 | 3.81 |
| | Polyethylene Glycol (Molecular | | |
| 20 | weight 10000) | 37.45 | 0.48 |
| 21 | Tergitol 15-S-30 | 36.51 | 1.47 |
| 22 | Triton X-705 | 33.45 | 0.99 |
| 23 | Tergitol NP30 | 33.83 | 0.32 |
| 24 | Purified Hostapur SAS | 14.76 | 1.32 |
| | Glycolic acid ethoxylate lauryl ether | | |
| 25 | (mw 739) | 32.39 | 1.27 |
| 26 | Dequest P9030 | 34.12 | 1.79 |
| 27 | No Immersion treatment performed | 38.55 | 0.12 |

The lower the average reflectance (%) indicates that more surface of the pieces is covered with pyramids after the immersion pre-texturing treatment. For this embodiment, for which no IPA was used in the texturing (etching) step, and the texturing times were limited, it was still possible to nucleate the pyramids and achieve reflectance less than 35% using many of the pre-texturing compositions of this invention.

### Example 5

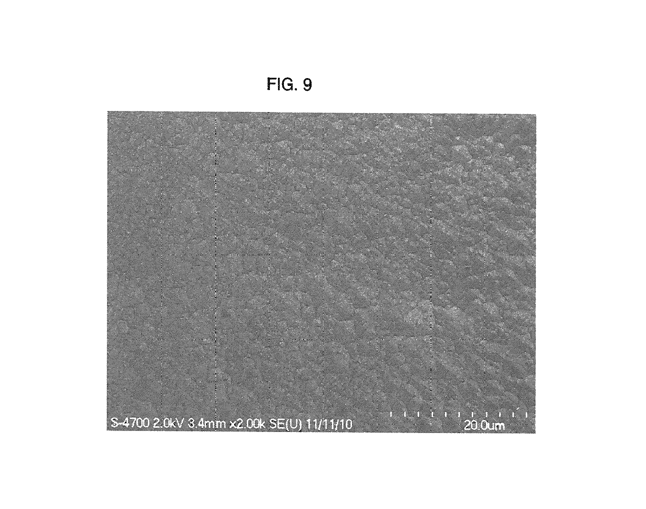

An alkaline pre-texturing composition was evaluated for its impact on texturing of the silicon wafer in the absence of isopropyl alcohol. Formulation 28 consisted of 1 wt% KOH and 3 wt% of Hostapur SAS Surfactant (purified acid form), balance being DI water. As-cut monocrystalline wafer pieces were first treated with 20% KOH solution at 65°C for 5 minutes to remove the saw damage from the surface, followed by a 3 minute DI water rinse. After this step, the wafer was exposed to Formulation 28 for 15 minutes at 80°C, and then 1 cycle of quick-dump-rinse (QDR) with DI water in the wet bench. The next step was texturing in a bath consisting of 4% KOH, balance DI water at 80° C for 40 minutes. There was no addition of IPA. The reflectance of the pieces was measured. The average weighted reflectance in the wavelength range of 300-830nm was found to be 17.8%. Figure 9 is a top-down SEM picture of a wafer created by the process described in Example 5 showing that the pyramid coverage is uniform over the surface.

### Example 6

The impact of IPA concentration on the reflectivity was evaluated with and without pre-texturing with Formulation 1. Wafers were processed under the following conditions:
Process E - (i) Saw Damage removal with 20wt % KOH at 65°C for 10 mins, (ii) 3 min overflow rinse with DI water at room temperature, (iii) texturing with 4 wt% KOH in DI water with 0.25 wt%, 0.5 wt%, 1 wt% or 2 wt% isopropanol with the balance DI water, (iv) 3 min overflow rinse with DI water at room temperature.
Process F - (i) Saw Damage removal with 20wt % KOH at 65C for 10 mins, (ii) 3 min overflow rinse with DI water at room temperature, (ii) immersion in Formulation 1 for 10 minutes at 80°C, (iv) then 1 cycle of quick-dump-rinse (QDR) with DI water in the wet bench, (v) texturing with 4 wt% KOH in DI water with 0.25 wt%, 0.5 wt%, 1 wt% or 2 wt% isopropanol with the balance DI water, (v) 3 min overflow rinse with DI water at room temperature.

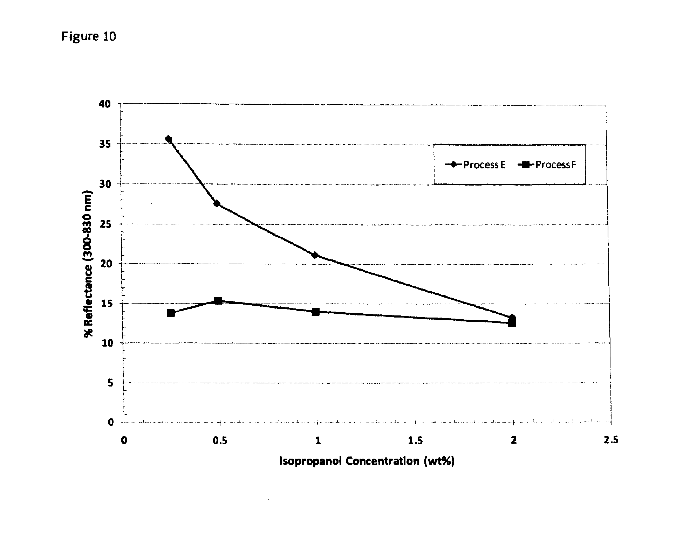

Figure 10 shows that Process F in which Formulation 1 is used prior to texturing is much less sensitive to the concentration of isopropanol than Process E.

### Example 7

Monocrystalline silicon wafer pieces (3 cmX 5 cm) were separately processed in each of the following process sequences:
Process G: i) Saw damage removal in 20% KOH solution for 5 min at 80°C followed by 6 minute DI water rinse, (ii) texturing in a solution containing 4% KOH + 2% Isopropanol (IPA) at 80°C for various times, followed by 6 minute DI water rinse (Turnover rate approximately 0.66 container volume/minute).
Process H: i) Immersion in Formulation 1 for 5 minutes at 80° C, followed by 6 min DI water rinse (Turnover rate approximately 0.66 container volume/minute) ii) Saw damage removal in 20% KOH solution for 5 min at 80 C followed by 6 min DI water rinse, (iii) texturing in a solution containing 4% KOH + 2% Isopropanol (IPA) at 80° C for various times, followed by 6 minute DI water rinse.

The flow rate for DI water over-flow rinse used in above examples was approximately 6 Liters/min, which is equivalent to 0.66 container volume/min.

The silicon loss was measured in the texturing step by measuring the weight change of the wafer piece just before and after the texturing step and calculating the total silicon layer thickness etched using 2.33 as the density of silicon. Wafer reflectivity measurements are made on the Perkin-Elmer Lambda 900 UV/VIS/NIR Spectrometer. The instrument was fitted with an integrating sphere to capture the reflected radiation.

Table 5 provides the silicon etch rate data and weighted average % reflectance in the range of 300-830 nm range.

**Table 5**

| | Si Loss (Microns) | | Weighted Average % Reflectance | |
|---|---|---|---|---|
| Texture Time | Process | Process | | |
| (min) | G | H | Process G | Process H |
| 5 | 9.0 | 5.9 | 28.11 | 13.70 |
| 10 | 13.6 | 8.5 | 24.06 | 13.36 |
| 15 | 23.5 | 7.4 | 23.62 | 13.59 |

Exposing the silicon wafers pieces to Formulation 1, resulted in reduced silicon loss during the texturing step, while at the same time reducing the reflectance after the texturing step. It is known that the silicon build-up in texturing solution due to etching of the silicon by the texturing solution reduces bath life of the texturing solution. By using pre-texture treatment with formulations in this disclosure, the rate of silicon loss in texturing is reduced and the time needed to texture is also reduced. As a result silicon build-up after processing a batch of silicon wafer in the texturing bath can be reduced compared to when no such treatment is used previous to the texturing step. As a result of a lower rate of silicon build-up, a larger number of wafer batches can be textured with the same bath of texturing solutions when the pre-texturing compositions of this invention are used prior to the texturing step.

### Example 8

Table 6 provides the compositions of Formulations 29-33, which comprise Dow Antifoam 1430, a defoaming agent, also referred to as anitifoaming agent, or antifoam. Dow Antifoam 1430 is a proprietary silicone emulsion (silicone surfactant) manufactured by Dow Chemicals. Antifoam compounds are added to reduce volume of the foam generated in a process that uses foaming surfactant in the formulation. High foam volume may be undesirable since the foam may spill over process tanks and also may create issues in disposing of the process solutions. While using the silicone antifoam (silicone surfactant) for primarily foam control, it unexpectedly provides a benefit in reducing the pyramid size.

**Table 6**

| Formulation# | Oxalic Acid (wt%) | Hostapur SAS (Purified acid form) (wt%) | KOH (wt%) | Dow 1430 Concentration Antifoam (wt%) | Water (wt%) |
|---|---|---|---|---|---|
| 29 | 1 | 2 | 1.54 | 0 | 95.46 |
| 30 | 1 | 2 | 1.54 | 0.0025 | 95.46 |
| 31 | 1 | 2 | 1.54 | 0.005 | 95.46 |
| 32 | 1 | 2 | 1.54 | 0.01 | 95.45 |
| 33 | 1 | 2 | 1.54 | 0.05 | 95.41 |

| | | | | | |
|---|---|---|---|---|---|
| (Dow Antifoam 1430 is assumed to be a pure compound for calculation of additions in the absence of certificate of analysis data.) | | | | | |

Monocrystalline wafer pieces were processed with following process sequence: (i) Pre-texture immersion in one of Formulations 1 and 29-33 for 5 minutes at 80°C, followed by 6 minute DI water overflow rinsing; and (ii) Texturing in 3%KOH +4%IPA solution for 15 minutes at 80°C.

A comparative texturing study without any pre-texture immersion was also performed. Texturing was done by immersing the wafer pieces in the 3% KOH + 4% IPA solution at 80°C for 15 minutes.

Measurements consisted of: (1) measurement of the contact angle with DI water droplets on the silicon surface before and after texturing, (2) Si loss measurements due to the texturing as per the method described in Example 7, (3) reflectance measurements as described above in Example 1, and (4) Average pyramid size measurements as described above in Example 1. Contact angle measurements were performed using Rame Hart goniometer. The measurements of contact angle were performed approximately 10 seconds after placing the water drop on the surface of the wafer.

**Table 7:**

| Pre-texture Treatment Solution | Contact angle After texture | Contact angle Before Texture | Si Loss (um) | Average Reflectance( %) | Pyramid height (microns) |
|---|---|---|---|---|---|
| 29 | 48.22 | 10.2 | 10.03 | 13.60 | 3.07 |
| 30 | 50.89 | 8.7 | 8.99 | 13.19 | 2.99 |
| 31 | 67.05 | 7.5 | 9.16 | 14.41 | 2.67 |
| 32 | 62.68 | 9.8 | 6.80 | 14.77 | 1.89 |
| 33 | 68.12 | 11.6 | 10.27 | 14.44 | 1.88 |
| 1 | 68.53 | 7.4 | 9.75 | 15.46 | 6.13 |
| No Pre-texture Treatment | 56.31 | 16.6 | 18.36 | 14.31 | 11.30 |

Compositions of this invention comprising Dow Antifoam 1430 showed reduced pyramid size. Decreased pyramid size (height) is desired for reducing the roughness of textured surface, which may be beneficial for improving conformity of the passivation layer deposited subsequently on the surface and reducing the width of contact lines screen printed on the surface. The results also show that the pre-texture immersion reduces the contact angle of the silicon surface, which may be helpful in pyramid nucleation.

Table 8 provides the foaming data generated using Ross Miles foam testing apparatus. The foam height was measured at 0 and 5 minutes after the generating the foam.

**Table 8:**

| | **Foam Height (cm) at:** | |
|---|---|---|
| Formulation | **Time 0** | **5 minutes** |
| 29 | 17.5 | 17.0 |
| 31 | 10.0 | 0.0 |
| 1 | 16.5 | 15.0 |

The addition of approximately, or at least 0.005% is sufficient to suppress foaming of the formulation.

### Example 9

Monocrystalline silicon wafers pieces (3 cmX 5 cm) were processed with following process sequence:
(i) Saw damage removal in 20 wt% KOH solution for 5 min at 80°C followed by 6 min DI water rinse, (ii) Immersion in Formulations 34-36 for 5 minutes at 80°C, followed by 6 min DI water rinse (Turnover rate approximately 0.66 container volume/minute) (iii) texturing in a solution containing 4 wt% KOH + 2 wt% Isopropanol (IPA) at 80° C for 5 minutes, followed by 6 minute DI water rinse.

Formulation 34 was 2 wt% Sodium Dodecyl Sulfate (from Sigma Aldrich Corporation) + 98 wt% water.

Formulation 35 was 2 wt% Sodium Laureth Sulfate (2 ethoxylate groups) (obtained as Rhodapex® ES-2, product of Rhodia Corporation).

Formulation 36 was 2 wt% N,N-Dimethyl-N-dodecylglycine betaine, N-(Alkyl C10-C16)-N,N-dimethylglycine betaine (obtained as Empigen® BB detergent from Sigma Aldrich Corporation.

Formulation 37 was 2 wt% Oleic Sulfonate (obtained as Calfoam® OS-45S from Pilot Chemicals).

Reflectance was measured on the wafer pieces after texturing as previously described.

| | Weighted Average |
|---|---|
| Formulation | Reflectance (400-830 nm) |
| 34 | 15.83 |
| 35 | 14.50 |
| 36 | 14.84 |
| 37 | 18.25 |

Low reflectance was achieved in a short texturing time with the pre-texturing treatment of this invention.

The invention further relates to the numbered items
1. A pre-texturing composition for texturing silicon wafers, wherein said composition comprises one or more surfactants.
2. The pre-texturing composition of item 1 comprising one or more anionic, cationic, non-ionic, and zwitterionic surfactants or mixtures thereof.
3. The pre- texturing composition of item 1 wherein said one or more surfactants comprise at least one surfactant selected from the group consisting of alkylphenol ethoxylates, polyoxyethylenated polyoxypropylene glycols, polyoxyethylenated mercaptans, long chain carboxylic acid esters, glyceryl and polyglyceryl esters of natural fatty acids, propylene glycol esters, sorbitol esters, polyoxyethylenated sorbitol esters, polyoxyethylene glycol esters, polyoxyethylenated fatty acids, alkanol amides, acetylenic glycols, polyoxyethylenated silicones, n-alkylpyrrolidones, alkylpolyglycosides, silicone surfactants, fluorochemical surfactants,octyl and nonyl phenol ethoxylates, acetylenic diol type of surfactants, alcohol ethoxylates, phenyl ethoxylates, amine ethoxylates, glucosides, glucamides, polyethylene glycols, and poly(ethylene glycol-co-propylene glycol) or mixtures thereof.
4. The pre-texturing composition of item 1 wherein said one or more surfactants comprise at least one surfactant selected from the group consisting of straight chain fatty acids and/or salts thereof, coconut oil fatty acid derivatives, tall oil acid derivatives, sarcosides, aceylated polypeptides, lignin sulfonates, N-acyl-n-alkyltaurates, petroleum sulfonates, paraffin sulfonates, sulfosuccinate esters, alkylnapthalenesulfonates, isethionates, sulfuric acid esters, sulfated linear primary alcohols, sulfated polyoxyethylenated straight chain alcohols, sulfated triglyceride oils, phosphoric and polyphosphoric acid esters and perfluorinated anionics, or mixtures thereof.
5. The pre-texturing composition of item 1, wherein said one or more surfactants comprises at least one surfactant selected from the group consisting of long chain amines and their salts, diamines and polyamines and their salts, quaternary ammonium salts, polyoxyethylenated long chain amines, quaternized polyoxyethylenated (POE) long chain amines, amine oxides, N-alkyl derivatives of simple amino acids, glycine, betaine and amino propionic acids, imidazolines, and sulfobetaines, or mixtures thereof.
6. The pre-texturing composition of item 1 wherein said one or more surfactants comprise one or more of the surfactants selected from the group consisting of linear alkylbenzenesulfonates (LAS), secondary alylbenzenesulfonate, fatty alcohol sulfates (FAS), secondary alkanesulfonates (SAS), fatty alcohol ether sulfates (FAES), α-olefin sulfonates, alkyl betaine surfactant and silicone surfactants..
7. The pre-texturing composition of item 1 wherein said one or more surfactants comprise at least one selected from the group consisting of secondary alkane sulfate, lauryl sulfate, lauryl ether sulfate, and N-(Alkyl C10-C16)-N,N-dimethylglycine betaine or mixtures thereof.
8. The pre-texturing composition of item 7 further comprising one or more organic acids, one or more optional bases, one or more optional anti-foaming agents and one or more optional corrosion inhibitors.
9. The pre-texturing composition of item 1 wherein said one or more surfactants comprises surfactant having the following structure: 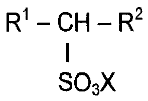 where R¹ and R² are independently alkyl groups or phenyl groups comprising 1-20 carbons and X is hydrogen or a cation selected from the group consisting of Na, K, tetramethyl ammonium, tetraethyl ammonium, triethanol amine, and ammonium.
10. The pre-texturing composition of item 9 further comprising silicone surfactant.
11. The pre-texturing composition of item 1 wherein said surfactant comprises one or more secondary alkane sulfonate surfactants.
12. The pre-texturing composition of item 1 wherein said one or more surfactants are present in the composition from 0.01 wt% to 30 wt% of a total weight of the composition and said composition further comprises water.
13. A method of texturing a silicon wafer comprising the step of:
   wetting said wafer with a pre-texturing composition comprising one or more surfactants.
14. A method of texturing a silicon wafer comprising the step of:
   wetting said wafer with a pre-texturing composition comprising one or more anionic, cationic, non-ionic and zwitterionic surfactants or mixtures thereof.
15. The method of item 13 wherein said one or more surfactants comprises at least one surfactant selected from the group consisting of linear alkylbenzenesulfonates (LAS), secondary alkylbenzenesulfonate, fatty alcohol sulfates (FAS), secondary alkanesulfonates (SAS), fatty alcohol ether sulfates (FAES), α-olefin sulfonates, alkyl betaine surfactant and silicone surfactants, or mixtures thereof.
16. The method of item 14 further comprising the step of:
   wetting said wafer with an etching composition after said step of wetting said wafer with a pre-texturing composition.
17. The method of item 16 further comprising between said wetting steps, a step of rinsing said wafer with a rinsing solution.
18. The method of item 16 further comprising prior to either wetting step the step of wetting said wafer with a saw damage removal composition or a pre-cleaning composition.
19. The method of item 18 where said etching composition is substantially free of surfactant.

## Claims

1. A pre-texturing composition for texturing silicon wafers, wherein said composition comprises one or more surfactants.

2. The pre-texturing composition of claim 1 comprising one or more anionic, cationic, non-ionic, and zwitterionic surfactants or mixtures thereof.

3. The pre- texturing composition of claims 1 or 2 wherein said one or more surfactants comprise at least one surfactant selected from the group consisting of alkylphenol ethoxylates, polyoxyethylenated polyoxypropylene glycols, polyoxyethylenated mercaptans, long chain carboxylic acid esters, glyceryl and polyglyceryl esters of natural fatty acids, propylene glycol esters, sorbitol esters, polyoxyethylenated sorbitol esters, polyoxyethylene glycol esters, polyoxyethylenated fatty acids, alkanol amides, acetylenic glycols, polyoxyethylenated silicones, n-alkylpyrrolidones, alkylpolyglycosides, silicone surfactants, fluorochemical surfactants,octyl and nonyl phenol ethoxylates, acetylenic diol type of surfactants, alcohol ethoxylates, phenyl ethoxylates, amine ethoxylates, glucosides, glucamides, polyethylene glycols, and poly(ethylene glycol-co-propylene glycol) or mixtures thereof.

4. The pre-texturing composition of claims 1 to 3 wherein said one or more surfactants comprise at least one surfactant selected from the group consisting of straight chain fatty acids and/or salts thereof, coconut oil fatty acid derivatives, tall oil acid derivatives, sarcosides, aceylated polypeptides, lignin sulfonates, N-acyl-n-alkyltaurates, petroleum sulfonates, paraffin sulfonates, sulfosuccinate esters, alkylnapthalenesulfonates, isethionates, sulfuric acid esters, sulfated linear primary alcohols, sulfated polyoxyethylenated straight chain alcohols, sulfated triglyceride oils, phosphoric and polyphosphoric acid esters and perfluorinated anionics, or mixtures thereof.

5. The pre-texturing composition of claims 1 to 4, wherein said one or more surfactants comprises at least one surfactant selected from the group consisting of long chain amines and their salts, diamines and polyamines and their salts, quaternary ammonium salts, polyoxyethylenated long chain amines, quaternized polyoxyethylenated (POE) long chain amines, amine oxides, N-alkyl derivatives of simple amino acids, glycine, betaine and amino propionic acids, imidazolines, and sulfobetaines, or mixtures thereof.

6. The pre-texturing composition of claims 1 to 5 wherein said one or more surfactants comprise one or more of the surfactants selected from the group consisting of linear alkylbenzenesulfonates (LAS), secondary alylbenzenesulfonate, fatty alcohol sulfates (FAS), secondary alkanesulfonates (SAS), fatty alcohol ether sulfates (FAES), α-olefin sulfonates, alkyl betaine surfactant and silicone surfactants..

7. The pre-texturing composition of claims 1 to 6 wherein said one or more surfactants comprise at least one selected from the group consisting of secondary alkane sulfate, lauryl sulfate, lauryl ether sulfate, and N-(Alkyl C10-C16)-N,N-dimethylglycine betaine or mixtures thereof.

8. The pre-texturing composition of claim 7 further comprising one or more organic acids, one or more optional bases, one or more optional anti-foaming agents and one or more optional corrosion inhibitors.

9. The pre-texturing composition of claims 1 to 8 wherein said one or more surfactants comprises surfactant having the following structure: 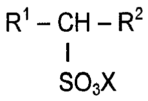 where R¹ and R² are independently alkyl groups or phenyl groups comprising 1-20 carbons and X is hydrogen or a cation selected from the group consisting of Na, K, tetramethyl ammonium, tetraethyl ammonium, triethanol amine, and ammonium.

10. The pre-texturing composition of claim 9 further comprising silicone surfactant.

11. The pre-texturing composition of claims 1 to 9 wherein said surfactant comprises one or more secondary alkane sulfonate surfactants.

12. The pre-texturing composition of claims 1 to 11 wherein said one or more surfactants are present in the composition from 0.01 wt% to 30 wt% of a total weight of the composition and said composition further comprises water.

13. A method of texturing a silicon wafer comprising the step of:
wetting said wafer with a pre-texturing composition comprising one or more surfactants.

14. A method of claim 13, wherein the surfactant is selected from the group consisting of:
anionic, cationic, non-ionic and zwitterionic surfactants or mixtures thereof.

15. The method of claims 13 to 14 wherein said one or more surfactants comprises at least one surfactant selected from the group consisting of linear alkylbenzenesulfonates (LAS), secondary alkylbenzenesulfonate, fatty alcohol sulfates (FAS), secondary alkanesulfonates (SAS), fatty alcohol ether sulfates (FAES), α-olefin sulfonates, alkyl betaine surfactant and silicone surfactants, or mixtures thereof.

16. The method of claims 13 to 15 further comprising the step of:
wetting said wafer with an etching composition after said step of wetting said wafer with a pre-texturing composition.

17. The method of claim 16 further comprising between said wetting steps, a step of rinsing said wafer with a rinsing solution.

18. The method of claims 16 to 17 further comprising prior to either wetting step the step of wetting said wafer with a saw damage removal composition or a pre-cleaning composition.

19. The method of claims 16 to 18 where said etching composition is substantially free of surfactant.
